(19) **Europäisches Patentamt European Patent Office Office européen des brevets**

(11) **EP 3 981 829 B1**

(12) **EUROPEAN PATENT SPECIFICATION**

(45) Date of publication and mention of the grant of the patent:
**25.12.2024 Bulletin 2024/52**

(21) Application number: **20849861.8**

(22) Date of filing: **05.08.2020**

(51) International Patent Classification (IPC):
*C08J 5/18* (2006.01)    *B32B 7/02* (2019.01)
*C08J 7/00* (2006.01)    *C08L 83/04* (2006.01)
*H01L 23/36* (2006.01)    *B32B 27/00* (2006.01)
*H05K 7/20* (2006.01)

(52) Cooperative Patent Classification (CPC):
(C-Sets available)
**H01L 23/3737; C08J 5/18; C08J 7/123;**
C08G 77/12; C08G 77/20; C08J 2383/04;
C08K 2003/2227      (Cont.)

(86) International application number:
**PCT/JP2020/030086**

(87) International publication number:
**WO 2021/025089 (11.02.2021 Gazette 2021/06)**

(54) **THERMALLY CONDUCTIVE SHEET AND PRODUCTION METHOD THEREFOR**

WÄRMELEITFÄHIGE FOLIE UND HERSTELLUNGSVERFAHREN DAFÜR

FEUILLE THERMOCONDUCTRICE ET SON PROCÉDÉ DE PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.08.2019 JP 2019146671**

(43) Date of publication of application:
**13.04.2022 Bulletin 2022/15**

(73) Proprietor: **Sekisui Polymatech Co., Ltd.**
**Saitama-city, Saitama 338-0837 (JP)**

(72) Inventors:
• **ISHIGAKI, Tsukasa**
 **Saitama-city, Saitama 338-0837 (JP)**

• **IWAZAKI, Hiromichi**
 **Saitama-city, Saitama 338-0837 (JP)**

(74) Representative: **Ter Meer Steinmeister & Partner Patentanwälte mbB**
**Nymphenburger Straße 4**
**80335 München (DE)**

(56) References cited:
**EP-A1- 1 180 798**    **EP-A1- 1 186 689**
**WO-A1-2017/187940**    **JP-A- 2001 316 502**
**JP-A- 2011 231 242**    **JP-A- 2018 186 286**
**JP-A- H10 150 132**

EP 3 981 829 B1

(52)  Cooperative Patent Classification (CPC): (Cont.)

C-Sets
**C09D 183/04, C08L 83/00, C08K 3/046, C08K 3/22**

## Description

Technical Field

The present invention relates to a thermally conductive sheet and a method for manufacturing the same.

Background Art

In electronic equipment such as computers, automobile parts, and cellular phones, heat-dissipating bodies such as heat sinks are generally used for dissipating heat produced from heating elements such as semiconductor devices and machine parts. It is known that a thermally conductive sheet is disposed between a heating element and a heat-dissipating body for the purpose of increasing the heat transfer efficiency to the heat-dissipating body.

A thermally conductive sheet is generally used by being compressed when disposed inside electronic equipment, and high flexibility is required. Therefore, the thermally conductive sheet is formed by blending a filling material having thermal conductivity into a matrix including a resin having high flexibility such as a rubber or a gel.

For thermally conductive sheets, various attempts to increase heat dissipating properties are made, and, for example, a method for increasing the amount of a thermally conductive filler filled, and orienting a filling material having anisotropy such as carbon fibers in the thickness direction are widely known (for example, PTL1 and PTL2).

A thermally conductive sheet may be fixed to an adherend face, but on the other hand may be slid or the like when incorporated into electronic equipment, and therefore it is also known that while one face is made an adhesive face, the other face is made a non-adhesive face. For example, PTL3 discloses that by fabricating a molded sheet containing carbon fibers oriented in the thickness direction with a molding mold and cutting the molded sheet in two along the plane direction, a thermally conductive sheet in which the mold-molded face is an adhesive face and the cut face is a non-adhesive face is obtained. PTL4 refers to a heat transfer sheet is characterized by comprising a polymer part and a heat transfer member and having the surface subjected to non-adhesion treatment. PTL5 is directed to a piezoelectric vibrator that has three vibrating branches and operates in a longitudinal primary vibration mode.

Citation List

Patent Literature

PTL1: JP 2016-000506 A
PTL2: WO 2016/208458
PTL3: JP 2011-231242 A
PTL4: JP 2001 316502 A
PTL5: JP H10 150132 A

Summary of Invention

Technical Problem

However, when the amount of a thermally conductive filler filled is increased in order to increase the heat dissipating properties of a thermally conductive sheet, the thermally conductive filler present in the vicinity of the sheet surfaces falls off the sheet, and problems such as the contamination of adherends such as a heating element and a heat-dissipating body and a decrease in heat dissipating properties may occur.

In addition, in thermally conductive sheets designed to prevent the falling off of the thermally conductive filler, problems such as a large decrease in thermal conductivity and the deterioration of slidability occur.

Thus, it is an object of the present invention to provide a thermally conductive sheet in which the falling off of a thermally conductive filler is prevented and which also has good slidability.

Solution to Problem

As a result of diligent studies, the present inventor has found that the object can be achieved by a thermally conductive sheet including a matrix including a silicone resin, and a thermally conductive filler, the thermally conductive sheet including a skin layer provided on a surface, and an oxide layer provided on the surface of the skin layer.

The present invention provides a thermally conductive sheet comprising a matrix comprising a silicone resin, and a thermally conductive filler, as defined in independent claims 1-3. Advantageous embodiments are disclosed in claims 4 to 6.

Advantageous Effects of Invention

According to the present invention, it is possible to provide a thermally conductive sheet in which while the falling off of a thermally conductive filler is prevented, the slidability is good.

Brief Description of Drawings

[Fig. 1] Fig. 1 is a cross-sectional view schematically showing one example of the thermally conductive sheet of the present invention.
[Fig. 2] Fig. 2 is a cross-sectional view schematically showing an example of a thermally conductive sheet not according to the present invention.
[Fig. 3] Fig. 3 is a schematic diagram of a thermal resistance measuring machine.
[Fig. 4] Fig. 4 is an explanatory diagram of a method for measuring a ball tack value.
[Fig. 5] Fig. 5 is a scanning electron micrograph of a cross section of the thermally conductive sheet of the present invention.
[Fig. 6] Fig. 6 is a scanning electron micrograph of a cross section of the thermally conductive sheet of the present invention.

Description of Embodiments

[Thermally Conductive Sheet]

The present invention is a thermally conductive sheet including a matrix including a silicone resin, and a thermally conductive filler, the thermally conductive sheet including a skin layer on a surface, and including an oxide layer on the surface of the skin layer.
Embodiments of the present invention will be described with reference to the drawings. The present invention is not limited to the contents of the following drawings.

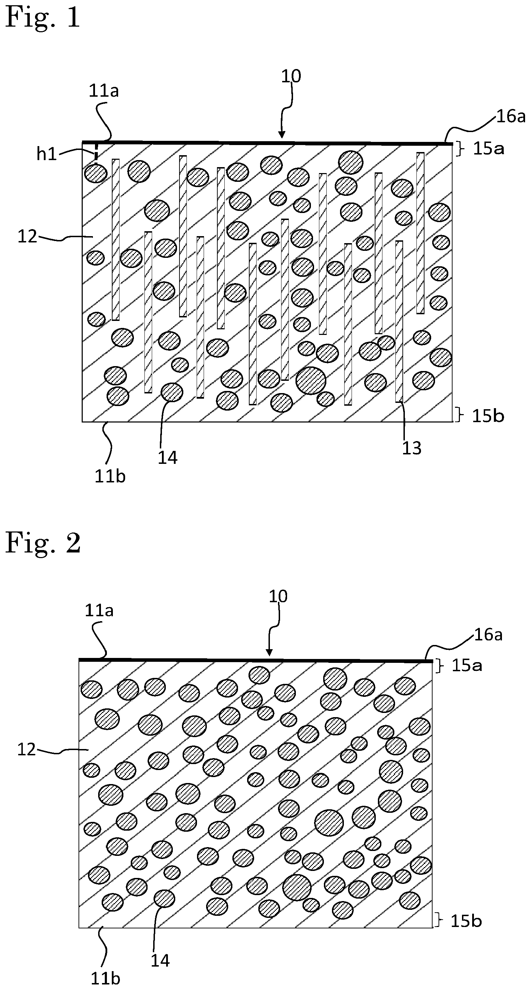

Fig. 1 is a cross-sectional view schematically showing one example of the thermally conductive sheet of the present invention. The thermally conductive sheet 10 of the present invention includes a matrix 12 including a silicone resin, and a thermally conductive filler dispersed in the matrix 12. The thermally conductive filler is composed of an anisotropic filler 13 oriented in the thickness direction of the thermally conductive sheet, and a non-anisotropic filler 14. In more detail, the non-anisotropic filling material 14 particles are interposed in the gaps between the anisotropic filling material 13 particles oriented in the thickness direction, to increase the thermal conductivity of the thermally conductive sheet in the thickness direction.
In Fig. 1, the anisotropic filler 13 is oriented in the thickness direction of the thermally conductive sheet 10, but the thermally conductive sheet 10 of the present invention is not limited to such a mode, and the anisotropic filler 13 may be randomly oriented in the sheet, or a thermally conductive filler including only the non-anisotropic filler 14 may be used as shown in Fig. 2 (not according to the invention). Especially, by using the anisotropic filler 13 oriented in the thickness direction and the non-anisotropic filler 14 in combination, the amount of the entire thermally conductive filler can be relatively decreased to effectively increase the thermal conductivity.

(Skin Layers)

Skin layers 15a and 15b are present in the vicinity of one surface 11a and the other surface 11b of the thermally conductive sheet 10. The skin layer contains the matrix 12 including the silicone resin and has a lower filling rate of the thermally conductive filler than other portions (portions other than the skin layer). Since the thermally conductive sheet 10 includes the skin layers, the falling off of the thermally conductive filler is prevented, and the contamination of adherends such as a heating element and a heat-dissipating body and a decrease in the thermal conductivity of the thermally conductive sheet 10 can be suppressed.
The thicknesses of the skin layers 15a and 15b are each preferably 0.1 to 10 $\mu$m, more preferably 0.3 to 5 $\mu$m, and further preferably 0.5 to 3 $\mu$m. When the thicknesses of the skin layers are equal to or more than these lower limit values, the falling off of the thermally conductive filler is easily prevented. When the thicknesses of the skin layers are equal to or less than these upper limit values, a decrease in thermal conductivity is easily suppressed.

The thickness of the skin layer can be obtained by observing a cross section of the thermally conductive sheet by a scanning electron microscope. Specifically, a scanning electron micrograph is obtained, and a perpendicular line is drawn in the direction of the inside of the thermally conductive sheet from a surface to obtain the distance h1 to the contact of the perpendicular line with the thermally conductive filler.

Then, similarly, a total of 50 perpendicular lines are drawn at equal intervals to obtain h1 to h50. 10 Large numerical values are excluded from the 50 measured values, and the average value of the remaining 40 measured values is taken as the thickness of the skin layer.

(Oxide Layer)

The thermally conductive sheet 10 of the present invention includes an oxide layer 16a on the surface of the skin layer 15a. The oxide layer 16a is formed by oxidizing the surface of the skin layer 15a. The formation of the oxide layer is preferably performed by irradiation with vacuum ultraviolet rays as described later. By including the oxide layer 16a, the surface 11a of the thermally conductive sheet 10 has weak adhesiveness and is a slightly adhesive face or a non-adhesive face. Which of a slightly adhesive face and a non-adhesive face is formed can be appropriately adjusted, for example, by the accumulated amount of light of ultraviolet irradiation as described later.

The surface 11a of the thermally conductive sheet 10 on the side including the oxide layer has a value of a ball tack test of 10 s or less as measured by changing the inclination angle of a test apparatus in accordance with JIS Z0237: 2009 to 8°. The ball tack value is an indicator of adhesiveness and means that the larger the value is, the higher the adhesiveness is. When the ball tack value is 10 s or less, the surface 11a is a slightly adhesive face or a non-adhesive face, and a thermally conductive sheet having good slidability can be obtained. In the present invention, whether a surface is a slightly adhesive face or a non-adhesive face is defined by the ball tack value, and when the ball tack value is 1 s or more and 10 s or less, the surface is taken as a slightly adhesive face, and when the ball tack value is less than 1 s, the surface is taken as a non-adhesive face. Further, when the ball tack value is more than 10 s, the surface is taken as an adhesive face. There is no particular lower limit, but when the slidability is extremely high, the ball tack value is about 0.2 s. The ball tack value is a value measured by the method of (1) to (2) described below and, in more detail, is measured by a method described in Examples.

(1) A test piece including the thermally conductive sheet is affixed to a flat plate so that the face that is the target of the ball tack test is a surface, and the flat plate is mounted so that the inclination angle $\alpha$ is 8°.

(2) A polyethylene terephthalate film is affixed to the upper portion of the test piece to form an approach, a steel ball having a diameter of 11 mm is placed on the polyethylene terephthalate film at a distance d1 (50 mm) upward from the upper end Q of the portion where the surface of the test piece is exposed, and then the time (s) when the steel ball reaches R at a position at a distance d2 (50 mm) toward the lower portion of the test piece from the upper end Q of the portion where the surface of the test piece is exposed, with the time when the steel ball passes the approach distance d1 (50 mm) being 0 s, is taken as the ball tack value.

The oxide layer may be formed on the skin layer 15b of the thermally conductive sheet 10, but the oxide layer is preferably not formed. When the oxide layer is not formed on the surface of the skin layer 15b, the surface 11b of the thermally conductive sheet 10 is an adhesive face. The thermally conductive sheet 10 can be fixed to an adherend face when incorporated into electronic equipment because the surface 11b is an adhesive face, and the thermally conductive sheet 10 is easily slid because the surface 11a has a slightly adhesive face or a non-adhesive face. Particularly when one surface 11a is a slightly adhesive face and the other surface 11b is an adhesive face, the thermally conductive sheet 10 has good slidability and is easily attached to the desired position when incorporated into electronic equipment, and positional displacement is less likely to occur.

For the oxide layer, the intensity at a binding energy of 104 eV to the intensity at a binding energy of 102 eV [I(104)/I(102)] is 0.13 or more in the photoelectron spectrum obtained by surface analysis by X-ray photoelectron spectroscopy. Here, the intensity at a binding energy of 102 eV [I(102)] is the intensity of binding energy based on the silicone (unit structure: SiO), and the intensity at a binding energy of 104 eV [I(104)] is the intensity of binding energy based on silica (unit structure: $SiO_2$). Therefore, when the value of I(104)/I(102) is large, it is meant that the proportion of silica formed by the oxidation of the silicone resin forming the surface of the skin layer is large.

The larger the value of I(104)/I(102) of the oxide layer, the more the adhesiveness of the sheet surface having the oxide layer decreases. From the viewpoint of making the sheet surface including the oxide layer the slightly adhesive face, the value of I(104)/I(102) is preferably 0.13 or more and 0.30 or less, more preferably 0.15 or more and 0.25 or less. From the viewpoint of making the sheet surface including the oxide layer the non-adhesive face, the value of I(104)/I(102) is preferably more than 0.30, more preferably more than 0.40, and usually 1.5 or less, preferably 1.0 or less.

Since the thermally conductive sheet 10 of the present invention includes the oxide layer 16a, the smoothness of the surface 11a improves. Generally, when an oxide layer is present, the thermal resistance value tends to increase and the heat dissipating properties tend to decrease, but in the thermally conductive sheet 10 of the present invention, the smoothness of the surface 11a is high, and therefore the degree of decrease in thermal conductivity can be decreased.

When the smoothness of the surface of the thermally conductive sheet 10 increases, the close adhesiveness improves, and heat can be effectively dissipated, when the thermally conductive sheet 10 is used for an adherend having a smooth surface. Particularly when the surface 11a of the thermally conductive sheet 10 is a non-adhesive face, the smoothness is higher, and the effect is more easily exhibited.

The surface 11a of the thermally conductive sheet of the present invention on the side including the oxide layer preferably has an arithmetic mean height (Sa) of 1.58 $\mu$m or less, an arithmetic mean peak curvature (Spc) of 910 [1/mm] or less, and a developed interfacial area ratio (Sdr) of 0.32 or less.

The arithmetic mean height (Sa) is a parameter that represents the average of the absolute values of the differences in the height of points with respect to the average plane of a surface and is an indicator of face roughness.

The arithmetic mean peak curvature (Spc) is a parameter that represents the arithmetic mean of the principal curvature of peaks in a defined region measured in accordance with ISO 25178. When this parameter is small, it is indicated that points that come into contact with an adherend (heating element or the like) are round. On the other hand, this value being large indicates that points that come into contact with an adherend (heating element or the like) are sharp.

The arithmetic mean peak curvature (Spc) can be calculated by measuring the surface profile of a predetermined measurement area (for example, a two-dimensional region of 1 mm$^2$) by a commercial laser microscope.

The developed interfacial area ratio (Sdr) is an indicator that indicates how much the developed area (surface area) of a defined region increases with respect to the area (for example, 1 mm$^2$) of the defined region, and a completely flat face has a developed area ratio Sdr of 0.

When these arithmetic mean height (Sa), arithmetic mean peak curvature (Spc), and developed interfacial area ratio (Sdr) are in the fixed ranges, the surface 11a has high performance smoothness, and therefore the demerit of the decrease in thermal conductivity due to the formation of the oxide layer is easily decreased, and the close adhesiveness of the thermally conductive sheet 10 to a smooth adherend is easily improved.

The arithmetic mean height (Sa) is more preferably 1.40 $\mu$m or less, further preferably 1.0 $\mu$m or less, and further preferably 0.9 $\mu$m or less, and usually 0.1 $\mu$m or more.

The arithmetic mean curvature (Spc) is more preferably 880 [1/mm] or less, further preferably 770 [1/mm] or less, and further preferably 750 [1/mm] or less, and usually 100 [1/mm] or more.

The developed interfacial area ratio (Sdr) is more preferably 0.3 or less, further preferably 0.23 or less, and further preferably 0.20 or less, and usually 0.05 or more.

These, the arithmetic mean height (Sa), the arithmetic mean curvature (Spc), and the developed interfacial area ratio (Sdr), can be measured by methods described in Examples.

(Silicone Resin)

The thermally conductive sheet of the present invention includes a matrix including a silicone resin. The silicone resin has high flexibility and can be filled with a relatively large amount of a thermally conductive filler, and therefore the thermal resistance value of the thermally conductive sheet can be decreased.

The silicone resin is obtained by curing a reaction-curable silicone. Examples of the reaction-curable silicone include addition reaction-curable silicones, radical reaction-curable silicones, condensation reaction-curable silicones, ultraviolet- or electron beam-curable silicones, and moisture-curable silicones. Among reaction-curable silicones, addition reaction-curable silicones are preferably used. The addition reaction-curable silicones preferably include an alkenyl group-containing organopolysiloxane and a hydrogen organopolysiloxane.

The thermally conductive sheet may include a resin other than a silicone resin in a range that does not hinder the effects of the present invention. However, the content of the silicone resin is preferably 60% by mass or more, more preferably 90% by mass or more, and further preferably 100% by mass based on the total amount of the resins included in the thermally conductive sheet.

Examples of the resin other than a silicone resin include rubbers and elastomers.

Examples of the rubbers include acrylic rubbers, nitrile rubbers, isoprene rubbers, urethane rubbers, ethylene-propylene rubbers, styrene-butadiene rubbers, butadiene rubbers, fluororubbers, and butyl rubbers.

Examples of the elastomers include thermoplastic elastomers such as polyester-based thermoplastic elastomers and polyurethane-based thermoplastic elastomers, and thermosetting elastomers formed by curing a mixed liquid polymer composition including a base resin and a curing agent.

(Thermally Conductive Filler)

The thermally conductive sheet of the present invention contains a thermally conductive filler. Since the thermally conductive sheet contains the thermally conductive filler, the thermal conductivity of the thermally conductive sheet increases, and the heat dissipating properties are good when the thermally conductive sheet is used between a heating element and a heat- dissipating body inside electronic equipment. The content of the thermally conductive filler is preferably 60% by volume or more, more preferably 65 to 90% by volume, and further preferably 70 to 85% by volume based on the total amount of the thermally conductive sheet. When the content of the thermally conductive filler is equal to or more than the lower limit values, the thermal conductivity of the thermally conductive sheet improves. When the content of the thermally conductive filler is equal to or less than the upper limit values, the effect corresponding to the amount of the thermally conductive filler blended can be obtained.

In the thermally conductive sheet of the present invention, even when the content of the thermally conductive filler is high, such as when the content of the thermally conductive filler is equal to or more than the lower limit values, the falling off of the thermally conductive filler can be effectively prevented. Therefore, the contamination of adherend faces and the like, an increase in the thermal resistance value (a decrease in the thermal conductivity) of the thermally conductive sheet, and the like accompanying the falling off of the thermally conductive filler can be prevented.

The thermally conductive filler comprises an anisotropic filler and a non-anisotropic filler. By using the anisotropic filler and the non-anisotropic filler in combination, the thermal conductivity can be efficiently improved even if the total amount of both is not very large.

<Anisotropic Filler>

The anisotropic filler is a filling material having anisotropy in shape and is a filling material capable of orientation. Examples of the anisotropic filling material include fibrous materials and scaly materials. The anisotropic filling material generally has a high aspect ratio and preferably has an aspect ratio of more than 2, more preferably 5 or more. By setting the aspect ratio larger than 2, the anisotropic filling material is easily oriented in the thickness direction, and the thermal conductivity of the thermally conductive sheet is easily increased.

The upper limit of the aspect ratio is not particularly limited but is practically 100.

The aspect ratio is the ratio of the length in the long axis direction to the length in the short axis direction of the anisotropic filling material and means fiber length/fiber diameter for a fibrous material and means the long axis direction length/thickness of a scaly material for the scaly material.

The anisotropic filling material is preferably a fibrous material from the viewpoint of improving the thermal conductivity of the thermally conductive sheet.

The content of the anisotropic filling material is preferably 75 to 250 parts by mass, more preferably 100 to 200 parts by mass, based on 100 parts by mass of the silicone resin in the thermally conductive sheet. The content of the anisotropic filling material is preferably 10 to 35% by volume, more preferably 15 to 30% by volume, based on the total amount of the thermally conductive sheet when expressed in % by volume.

By setting the content of the anisotropic filling material at 75 parts by mass or more, the thermal conductivity is easily increased. By setting the content of the anisotropic filling material at 250 parts by mass or less, the viscosity of a mixed composition described later is easily suitable, and the orientability of the anisotropic filling material is good.

When the anisotropic filling material is fibrous, its average fiber length is preferably 10 to 500 $\mu$m, more preferably 20 to 200 $\mu$m. When the average fiber length is 10 $\mu$m or more, the anisotropic filling material particles come into suitable contact with each other, and heat transfer paths are ensured, and the thermal conductivity of the thermally conductive sheet is good.

On the other hand, when the average fiber length is 500 $\mu$m or less, the bulk of the anisotropic filling material decreases, and the silicone resin can be highly filled with the anisotropic filling material. Further, the electrical conductivity of the thermally conductive sheet is prevented from being higher than necessary.

The average fiber length can be calculated by observing the anisotropic filling material by a microscope. More specifically, it is possible to measure the fiber lengths of 50 arbitrary anisotropic filling material particles using, for example, an electron microscope or an optical microscope, and take their average value (arithmetic mean value) as the average fiber length.

When the anisotropic filling material is a scaly material, its average particle diameter is preferably 10 to 400 $\mu$m, more preferably 15 to 300 $\mu$m. The average particle diameter is particularly preferably 20 to 200 $\mu$m. By setting the average particle diameter at 10 $\mu$m or more, the anisotropic filling material particles easily come into contact with each other, and heat transfer paths are ensured, and the thermal conductivity of the thermally conductive sheet is good. On the other hand, when the average particle diameter is 400 $\mu$m or less, the bulk of the anisotropic filling material decreases, and the silicone resin can be highly filled with the anisotropic filling material.

For the average particle diameter of the scaly material, it is possible to observe the anisotropic filling material by a microscope and calculate the major axes as the diameters. More specifically, it is possible to measure the major axes of 50 arbitrary anisotropic filling material particles using, for example, an electron microscope or an optical microscope, and take their average value (arithmetic mean value) as the average particle diameter.

For the anisotropic filling material, a known material having thermal conductivity should be used, and one having electrical conductivity is generally used. The anisotropic filling material preferably has diamagnetism so that it can be subjected to magnetic field orientation, as described later.

Specific examples of the anisotropic filling material include carbon-based materials typified by carbon fibers and scaly carbon powders, metal materials typified by metal fibers, metal oxides, boron nitride, metal nitrides, metal carbides, and metal hydroxides. Among these, carbon-based materials are preferred because they have low specific gravity and good dispersing ability in the silicone resin. Especially, graphitized carbon materials having high thermal conductivity are more preferred. The graphitized carbon materials have anisotropic diamagnetic susceptibility by the alignment of graphite planes in a predetermined direction. Boron nitride and the like also have anisotropic diamagnetic susceptibility by the alignment of crystal planes in a predetermined direction.

Therefore, from the viewpoint of allowing orientation in an arbitrary direction by magnetic field orientation, scaly boron nitride and graphitized carbon materials having anisotropic diamagnetic susceptibility as described above are preferred. In the present invention, the anisotropic filler comprises carbon fiber.

Here, the anisotropic diamagnetic susceptibility is a physical property value (CGS system of units) that indicates the anisotropy of the diamagnetic susceptibility of the anisotropic filling material. That is, this anisotropic diamagnetic susceptibility is a value obtained by subtracting, for example, from the magnetic susceptibility in the fiber axis direction or the in-plane direction of one face of a scale, the magnetic susceptibility in the direction perpendicular thereto, for the magnetic susceptibility of the anisotropic filling material produced by externally applying a magnetic field. This anisotropic diamagnetic susceptibility can be measured by a magnetic anisotropy torquemeter, a vibrating magnetometer, a superconducting quantum interference device (SQUID), or a known method such as a suspension method.

The anisotropic filling material generally has a thermal conductivity of 60 W/m·K or more, preferably 400 W/m·K or more, along the direction of anisotropy (that is, the long axis direction), which is not particularly limited. The thermal conductivity of the anisotropic filling material is, for example, 2000 W/m·K or less though its upper limit is not particularly limited. The method for measuring the thermal conductivity is a laser flash method.

When the anisotropic filling material is used, one anisotropic filling material may be used alone, or two or more anisotropic filling materials may be used in combination. For example, as the anisotropic filling material, at least two anisotropic filling materials having different average particle diameters or average fiber lengths from each other may be used. It is considered that when anisotropic filling materials having different sizes are used, small anisotropic filling material particles enter between relatively large anisotropic filling material particles, and thus the silicone resin can be filled with the anisotropic filling materials at high density, and the heat conduction efficiency is increased.

For the carbon fibers used as the anisotropic filling material, graphitized carbon fibers are preferred. As the scaly carbon powder, a scaly graphite powder is preferred. Of these, graphitized carbon fibers are more preferred for the anisotropic filling material.

In each graphitized carbon fiber, the crystal planes of graphite are connected in the fiber axis direction, and the graphitized carbon fiber has high thermal conductivity in the fiber axis direction. Therefore, by aligning the fiber axis directions in a predetermined direction, the thermal conductivity in the particular direction can be increased. In the scaly graphite powder, the crystal planes of graphite are connected in the in-plane direction of one face of a scale, and the scaly graphite powder has high thermal conductivity in the in-plane direction. Therefore, by aligning the one faces of scales in a predetermined direction, the thermal conductivity in the particular direction can be increased. The graphitized carbon fibers and the scale graphite powder preferably have a high degree of graphitization.

As the graphitized carbon materials such as the graphitized carbon fibers and scaly graphite powder, those obtained by graphitizing the following raw materials can be used. Examples of the raw materials include condensed polycyclic hydrocarbon compounds such as naphthalene, and condensed heterocyclic compounds such as PAN (polyacrylonitrile) and pitch. Particularly, graphitized mesophase pitch, polyimides, and polybenzazole having a high degree of graphitization are preferably used. For example, by using mesophase pitch, the pitch is oriented in the fiber axis direction due to its anisotropy in a spinning step described later, and graphitized carbon fibers having excellent thermal conductivity in the fiber axis direction can be obtained.

The mode of use of mesophase pitch in the graphitized carbon fibers is not particularly limited as long as it can be spun. Mesophase pitch may be used alone or in combination with another raw material. However, using mesophase pitch alone, that is, graphitized carbon fibers having a mesophase pitch content of 100%, is most preferred in terms of higher thermal conduction, spinnability, and the stability of quality.

For the graphitized carbon fibers, those obtained by sequentially performing the treatments of spinning, infusibilization, and carbonization, followed by grinding or cutting to a predetermined particle diameter and then graphitization, or those obtained by sequentially performing the treatments of spinning, infusibilization, and carbonization, performing grinding or cutting after the carbonization, and then performing graphitization can be used. When grinding or cutting is performed before graphitization, a polycondensation reaction and a cyclization reaction proceed easily on surfaces newly exposed by the grinding, during graphitization treatment, and therefore graphitized carbon fibers in which the degree of graphitization is increased to still further improve the thermal conductivity can be obtained. On the other hand, when spun carbon fibers are graphitized and then ground, the carbon fibers after the graphitization are rigid and therefore easily ground, and a carbon fiber powder having a relatively narrow fiber length distribution can be obtained by short time grinding.

The fiber diameter of the graphitized carbon fibers is not particularly limited but is preferably 5 to 20 $\mu$m. When the fiber diameter is in the range of 5 to 20 $\mu$m, industrial production is easy, and the thermal conductivity of the obtained thermally conductive sheet can be increased.

The average fiber length of the graphitized carbon fibers is preferably 10 to 500 $\mu$m, more preferably 20 to 200 $\mu$m, as described above. The aspect ratio of the graphitized carbon fibers is preferably more than 2, more preferably 5 or more, as described above.

The thermal conductivity of the graphitized carbon fibers is not particularly limited, but the thermal conductivity in the fiber axis direction is preferably 400 W/m·K or more, more preferably 800 W/m·K or more.

The anisotropic filling material is oriented in the thickness direction in each thermally conductive layer. The orientation of the anisotropic filling material in the thickness direction more specifically refers to a state in which the proportion of the number of carbon fiber powder particles in which the angle of the fiber axis to the thickness direction of the thermally conductive sheet is less than 30° is more than 50%.

For the direction of the orientation of the anisotropic filling material, the angle of the fiber axis to the thickness direction is preferably 0° from the viewpoint of increasing the thermal conductivity. On the other hand, the anisotropic filling material can also be inclined in the range of 5 to 30° in that the load when the thermally conductive sheet is compressed can be decreased.

<Non-Anisotropic Filling Material>

The non-anisotropic filling material is a thermally conductive filling material that can be contained in the thermally conductive sheet alone or together with the anisotropic filling material. When both the non-anisotropic filler and the anisotropic filler are contained, the non-anisotropic filling material particles are interposed in the gaps between the oriented anisotropic filling material particles, and a thermally conductive sheet having high thermal conductivity is obtained.

The non-anisotropic filling material is a filling material having substantially no anisotropy in shape and is a filling material that is not oriented in a predetermined direction even in an environment in which the anisotropic filling material is oriented in the predetermined direction, such as under the generation of magnetic lines of force described later or under shear force action.

The aspect ratio of the non-anisotropic filling material is preferably 2 or less, more preferably 1.5 or less. When the non-anisotropic filling material having a low aspect ratio in this manner are contained, the filling material particles having thermal conductivity are suitably interposed in the gaps between the anisotropic filling material particles, and a thermally conductive sheet having high thermal conductivity is obtained. By setting the aspect ratio at 2 or less, an increase in the viscosity of a mixed composition described later can be prevented for high filling.

Specific examples of the non-anisotropic filling material include metals, metal oxides, metal nitrides, metal carbides, metal hydroxides, and carbon materials. Examples of the shape of the non-anisotropic filling material include spherical and irregular powders.

For the non-anisotropic filling material, examples of the metals can include aluminum, copper, and nickel. Examples of the metal oxides can include aluminum oxide, magnesium oxide, zinc oxide, and quartz. Examples of the metal nitrides can include boron nitride and aluminum nitride. Examples of the metal carbides include silicon carbide. Examples of the metal hydroxides include aluminum hydroxide. Further, examples of the carbon materials include spherical graphite.

Among these, aluminum oxide and aluminum are preferred in that those having high thermal conductivity and being spherical are easily available, and aluminum hydroxide is preferred in that it is easily available and in that the fire retardancy of the thermally conductive sheet can be increased.

For the non-anisotropic filling material, those having insulating properties are preferred. Specifically, metal oxides, metal nitrides, metal hydroxides, and metal carbides are preferably used. Especially, aluminum oxide and aluminum hydroxide are more preferred.

The average particle diameter of the non-anisotropic filling material is preferably 0.1 to 50 $\mu$m, more preferably 0.5 to 35 $\mu$m. The average particle diameter is particularly preferably 1 to 15 $\mu$m. By setting the average particle diameter at 50 $\mu$m or less, problems such as the disturbance of the orientation of the anisotropic filling material are less likely to occur. By setting the average particle diameter at 0.1 $\mu$m or more, the specific surface area of the non-anisotropic filling material is not larger than necessary, and the viscosity of a mixed composition is less likely to increase even if the non-anisotropic filling material is blended in a large amount, and the non-anisotropic filling material is easily highly filled.

The non-anisotropic filler may include a small particle diameter non-anisotropic filler having an average particle diameter of 0.1 or more and 15 $\mu$m or less, and a large particle diameter non-anisotropic filler having an average particle diameter of more than 15 $\mu$m and 100 $\mu$m or less. By using the small particle diameter non-anisotropic filler and the large particle diameter non-anisotropic filler in combination, the amount of the non-anisotropic filler filled into the silicone resin increases. In this case, the mass ratio of the small particle diameter non-anisotropic filler to the large particle diameter non-anisotropic filler is preferably in the range of 0.5 to 5, more preferably in the range of 1 to 3.

Further, the small particle diameter non-anisotropic filler preferably includes a first small particle diameter non-anisotropic filler having an average particle diameter of 0.1 $\mu$m or more and 3 $\mu$m or less, and a second small particle diameter non-anisotropic filler having an average particle diameter of more than 3 $\mu$m and 15 $\mu$m or less, from the viewpoint of increasing the amount filled.

The average particle diameter of the non-anisotropic filling material can be measured by observation by an electron microscope or the like. More specifically, it is possible to measure the particle diameters of 50 arbitrary non-anisotropic filling material particles using, for example, an electron microscope or an optical microscope, and take their average value (arithmetic mean value) as the average particle diameter.

The content of the non-anisotropic filling material is preferably in the range of 250 to 3000 parts by mass, more preferably in the range of 450 to 1500 parts by mass, based on 100 parts by mass of the silicone resin. The content of the non-anisotropic filling material is preferably 30 to 88% by volume, more preferably 40 to 80% by volume, based on the total amount of the thermally conductive sheet when expressed in % by volume.

The content of the non-anisotropic filler is preferably appropriately adjusted when the non-anisotropic filler is used alone as the thermally conductive filler and when the non-anisotropic filler is used in combination with the anisotropic filler.

When the non-anisotropic filler is used alone as the thermally conductive filler, the content of the non-anisotropic filler is preferably in the range of 300 to 3000 parts by mass, more preferably in the range of 500 to 1500 parts by mass, and further preferably in the range of 850 to 1300 parts by mass. When the content of the non-anisotropic filler is equal to or more than these lower limit values, the thermal conductivity of the thermally conductive sheet increases. When the content of the non-anisotropic filler is equal to or less than these upper limit values, the effect corresponding to the amount of the non-anisotropic filler blended can be obtained.

When the non-anisotropic filler and the anisotropic filler are used in combination, the content of the non-anisotropic filler is preferably in the range of 250 to 1000 parts by mass, more preferably in the range of 300 to 700 parts by mass, based on 100 parts by mass of the silicone resin. When the content of the non-anisotropic filler is equal to or more than these lower limit values, the amount of the non-anisotropic filling material interposed in the gaps between the anisotropic filling material particles is sufficient, and the thermal conductivity is good. When the content of the non-anisotropic filler is equal to or less than these upper limit values, the effect of increasing the thermal conductivity, corresponding to the content can be obtained, and the non-anisotropic filling material does not inhibit thermal conduction through the anisotropic filling material.

(Additives)

In the thermally conductive sheet of the present invention, various additives may be further blended into the matrix in a range that does not impair the function as the thermally conductive sheet. Examples of the additives include at least one or more selected from the group consisting of a dispersant, a coupling agent, a crosslinking accelerator, a curing accelerator, an adhesive, a fire retardant, an antioxidant, a colorant, an anti-settling agent, and the like.

(Physical Properties of Thermally Conductive Sheet)

The thermal resistance value of the thermally conductive sheet of the present invention is preferably 20°C/W or less, more preferably 2°C/W or less, further preferably 1°C/W or less, and particularly preferably 0.65°C/W or less, and usually 0.03°C/W or more. When the thermal resistance value is equal to or less than these upper limit values, the thermal conductivity of the thermally conductive sheet increases, and the heat dissipating properties are good. When the thermally conductive sheet includes an anisotropic filling material, the thermal resistance value can be decreased, and the heat dissipating properties are good. The thermal resistance value of the thermally conductive sheet is a value when the thermally conductive sheet is compressed by 20% in the thickness direction, and, in detail, can be measured by a method described in Examples.

When the thermally conductive sheet includes an anisotropic filling material, the thermal conductivity of the thermally conductive sheet in the thickness direction is preferably 6 W/m·K or more. There is no particular upper limit, but the upper limit is, for example, 50 W/m·K. When only a non-anisotropic filling material is used, the thermal conductivity of the thermally conductive sheet in the thickness direction is preferably 1 W/m·K or more. There is no particular upper limit, but the upper limit is, for example, 15 W/m·K. The thermal conductivity is measured by a method in accordance with ASTM D5470-06.

The thermally conductive sheet preferably has an E hardness of 5 to 80 as measured by a type E hardness meter in Japanese Industrial Standards JIS K6253. By setting the E hardness at 80 or less, the conformability to the shapes of a heating element and a heat-dissipating body is good, the close adhesiveness between the heating element and the heat-dissipating body and the thermally conductive sheet is good, and the thermal conductivity is excellent. When the E hardness is 5 or more, the retention of the shape is easy, preventing the orientation of the anisotropic filling material from being disturbed by compression to decrease the thermal conductivity.

The thickness of the thermally conductive sheet is not particularly limited but is preferably 0.05 to 5 mm, more preferably 0.1 to 5 mm, and further preferably 0.15 to 3 mm.

The thermally conductive sheet is used inside electronic equipment and the like. Specifically, the thermally conductive sheet is interposed between a heating element and a heat-dissipating body and thermally conducts heat emitted by the heating element to the heat-dissipating body, and the heat is dissipated from the heat-dissipating body. Here, examples of the heating element include various types of electronic parts such as CPUs, power amplifiers, and power supplies used inside electronic equipment. Examples of the heat-dissipating body include heat sinks, heat pumps, and metal housings for electronic equipment. The thermally conductive sheet is used in a state in which both surfaces adhere closely to a heating element and a heat-dissipating body respectively and in which the thermally conductive sheet is compressed.

[Method for Manufacturing Thermally Conductive Sheet]

A method for manufacturing a thermally conductive sheet according to the present invention is not particularly limited but preferably includes a skin layer forming step and an oxide layer forming step. Each step will be described below.

<Skin Layer Forming Step>

The skin layer forming step is the step of forming a skin layer on at least one surface of a thermally conductive sheet. Specifically, the skin layer forming step includes the following steps (S1) and (S2):

(S1) the step of preparing a mixed composition including a reaction-curable silicone and a thermally conductive filler,
(S2) the step of forming the mixed composition into a sheet shape and curing the mixed composition in the sheet shape with at least one surface of the mixed composition in the sheet shape being in a non-open state.

In the oxide layer forming step described later, an oxide layer is formed on the surface cured in the non-open state in the (S2) step. When the mixed composition in the sheet shape is cured with both faces of the mixed composition in the sheet shape being in the non-open state in the (S2) step, an oxide layer should be formed on at least one of both faces cured in the non-open state, and an oxide layer is preferably formed on only one face.

The curing performed in the non-open state is curing performed in a state in which a surface of the mixed composition in the sheet shape is brought into contact with a member such as a metal or a resin film, and a skin layer is formed by the curing. In the step (S2), the mixed composition in the sheet shape is preferably cured with both faces of the mixed composition in the sheet shape being in the non-open state. Specifically, the step (S2) is preferably performed using a mold inside which a hollow portion corresponding to a sheet shape is defined. That is, the mixed composition prepared in the step (S1) is preferably introduced into the hollow portion of the mold and cured in the mold. The curing is performed in a state in which both surfaces of the mixed composition are in contact with the member forming the mold, and therefore a thermally conductive sheet on both surfaces of which skin layers are formed is obtained. The mixed composition may be cured with release films disposed in the mold so as to be in contact with both surfaces of the mixed composition.

As another specific example of the step (S2), the mixed composition can also be cured in a state in which the mixed composition is sandwiched between two release films, with the thickness adjusted by a stretching roll or the like.

When the mixed composition includes an anisotropic filler, it is preferred that the mixed composition be placed in a magnetic field, the anisotropic filler be oriented along the magnetic field, and then the mixed composition be cured, in order to orient the anisotropic filler in the thickness direction of the thermally conductive sheet. Therefore, for example, the mixed composition introduced into the hollow portion of the mold is preferably oriented by a magnetic field and then cured.

For magnetic field orientation, the viscosity of the mixed composition is preferably 10 to 300Pa·s. By setting the viscosity of the mixed composition at 10Pa·s or more, the anisotropic filling material and the non-anisotropic filling material are less likely to settle. By setting the viscosity of the mixed composition at 300Pa·s or less, the fluidity is good, the anisotropic filling material is suitably oriented by a magnetic field, and the problem of too time-consuming orientation does not occur. The viscosity is viscosity measured at 25°C at a rotation speed of 10 rpm using a rotational viscometer (Brookfield viscometer DV-E, spindle SC4-14).

However, when an anisotropic filling material and a non-anisotropic filling material less likely to settle are used, or an additive such as an anti-settling agent is combined, the viscosity of the mixed composition may be less than 10Pa·s. When the anisotropic filling material need not be oriented, there is no particular upper limit, but by setting the viscosity of the mixed composition, for example, at 10 to 1000Pa·s or less, good coating properties are obtained.

Examples of the source of magnetic lines of force for applying magnetic lines of force in the magnetic field orientation manufacturing method include a superconducting magnet, a permanent magnet, and an electromagnet, and a superconducting magnet is preferred in that a magnetic field having high magnetic flux density can be generated. The magnetic flux density of the magnetic field generated from these sources of magnetic lines of force is preferably 1 to 30 T. When the magnetic flux density is 1 T or more, the anisotropic filling material including a carbon material or the like can be easily oriented. By setting the magnetic flux density at 30 T or less, the thermally conductive sheet can be practically manufactured.

<Oxide Layer Forming Step>

The oxide layer forming step is the step of forming an oxide layer on the surface of the skin layer. The oxide layer forming step includes a vacuum ultraviolet irradiation step. That is, the oxide layer is formed by irradiating the skin layer surface with vacuum ultraviolet rays (hereinafter also referred to as VUV). VUV means ultraviolet rays having a wavelength of 10 to 200 nm. Examples of the VUV light source include an excimer Xe lamp and an excimer ArF lamp.

Upon irradiation with VUV, the skin layer surface irradiated with VUV is activated, and part of the silicone resin turns into silica to form an oxide layer.

The VUV irradiation conditions are not particularly limited as long as a surface of the primary sheet can be activated. For example, VUV should be irradiated so that the accumulated amount of light in the VUV irradiation step is 25 to 3000 mJ/cm$^2$. With such an accumulated amount of light, the VUV-irradiated thermally conductive sheet surface is a slightly adhesive face or a non-adhesive face.

When a slightly adhesive face is formed on a thermally conductive sheet surface, the accumulated amount of light is preferably 25 to 800 mJ/cm$^2$, more preferably 50 to 600 mJ/cm$^2$, and further preferably 100 to 500 mJ/cm$^2$.

When a non-adhesive face is formed on a thermally conductive sheet surface, the accumulated amount of light is preferably more than 800 mJ/cm$^2$, more preferably 1000 to 3000 mJ/cm$^2$.

When the skin layers are formed on both faces of the thermally conductive sheet in the skin layer forming step, both skin layers may be subjected to VUV irradiation, but only one face is preferably subjected to VUV irradiation from the viewpoint of making one face of the thermally conductive sheet a slightly adhesive face or a non-adhesive face and the other face an adhesive face. The surface of the oxide layer formed by VUV irradiation has high smoothness, and the arithmetic mean height (Sa), the arithmetic mean curvature (Spc), and the developed interfacial area ratio (Sdr) for the surface are as described above.

Examples

The present invention will be described in more detail below by Examples, but the present invention is not limited in any way by these examples.

In the present Examples, evaluation was performed by the following methods.

[Thermal Resistance Value]

(1) 20% Compression Thermal Resistance Value

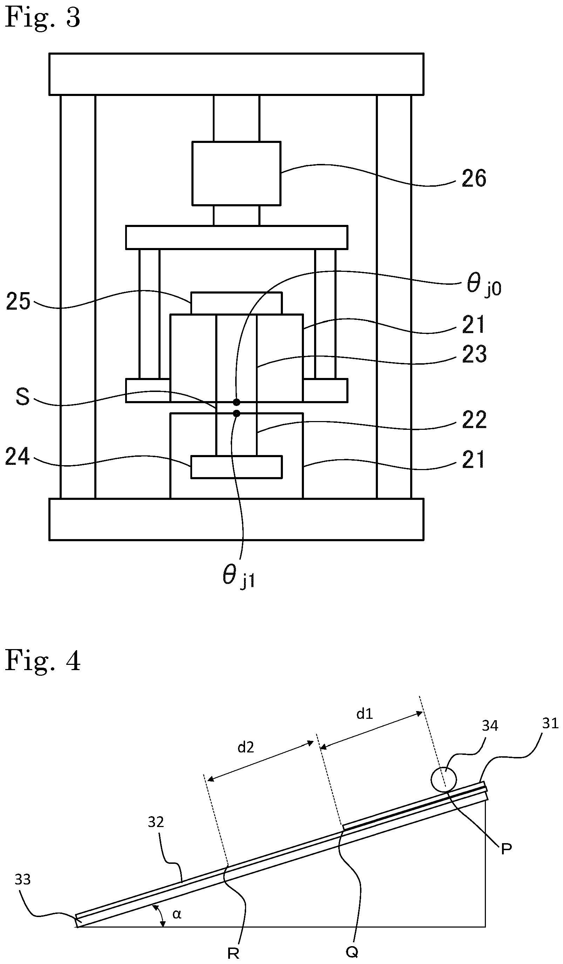

The thermal resistance value was measured by the method shown below, using a thermal resistance measuring machine as shown in Fig. 3. Specifically, for each sample, a test piece S having a size of 10 mm × 10 mm was fabricated for this test. Then, each test piece S was affixed on a copper block 22 having a measurement face of 10 mm × 10 mm and having its side faces covered with a thermal insulator 21, and sandwiched with an upper copper block 23, and a load was applied by a load cell 26 to compress the thickness of the test piece S by 20% (that is, compress the thickness to 80% of the thickness before compression). Here, the lower copper block 22 is in contact with a heater 24. The upper copper block 23 is connected to a heat sink 25 with a fan. Then, the heater 24 was allowed to generate heat with an amount of heat generation of 25 W, and 10 min after the temperature reached a generally steady state, the temperature of the upper copper block 23 ($\theta_{j0}$), the temperature of the lower copper block 22 ($\theta_{j1}$), and the amount of heat generation (Q) of the heater were measured, and the thermal resistance value of each sample was obtained from the following formula (1):

$$\text{thermal resistance} = (\theta_{j1} - \theta_{j0})/Q \ldots \text{formula (1)}$$

wherein $\theta_{j1}$ is the temperature of the lower copper block 22, $\theta_{j0}$ is the temperature of the upper copper block 23, and Q is the amount of heat generation.

Separately, the compression ratio when a load of 20 N was applied to the test piece (20 N compression ratio) using the thermal resistance measuring machine was also obtained.

[XPS Measurement]

For the surface of each of the thermally conductive sheets fabricated in the Examples and Comparative Examples on the side including an oxide layer, that is, the face irradiated with VUV, surface analysis by an X-ray photoelectron spectrometer (manufactured by ULVAC-PHI, Incorporated., "PHI 5000 VersaProbe II") was performed, and the intensity at a binding energy of 104 eV to the intensity at a binding energy of 102 eV [I(104)/I(102)] was obtained. As the X-ray source, monochromatic AlK$\alpha$ (12.5 W, 15 kV, beam diameter 200 $\mu$m) was used, and measurement was performed at a photoelectron take-off angle of 90°.

[Arithmetic Mean Peak Curvature (Spc), Arithmetic Mean Height (Sa), and Developed Interfacial Area Ratio (Sdr)]

For the surface of each of the thermally conductive sheets fabricated in the Examples and the Comparative Examples on the side including the oxide layer, surface property analysis was performed in accordance with ISO 25178 using a laser microscope (manufactured by KEYENCE CORPORATION, VK-X150). Specifically, the surface profile of a two-dimensional region having a surface area of 1000 $\mu$m $\times$ 1000 $\mu$m was measured at 10x lens magnification by a laser method. The average value when the measurement was performed in three parts for the same sample was adopted as the arithmetic mean peak curvature Spc.

Also for the arithmetic mean height (Sa) and the developed interfacial area ratio (Sdr), similarly, measurement was performed in three parts for the same sample, and the average values were taken as the arithmetic mean height (Sa) and the developed interfacial area ratio (Sdr) respectively.

[Ball Tack Value]

The way of obtaining the ball tack value will be described using Fig. 4.

Each of the thermally conductive sheets fabricated in the Examples and the Comparative Examples was adjusted to dimensions of a width of 10 mm and a length of 150 mm to form a test piece 32. A flat plate 33 (aluminum plate) larger than the test piece was provided, and the test piece was affixed to the flat plate so that the face that was the target of a ball tack test was a surface and so that a large height difference does not occur. Then, the flat plate to which the test piece was affixed was mounted so that the inclination angle $\alpha$ was 8°.

Then, a polyethylene terephthalate film 31 was affixed to the upper portion of the test piece 32 to form an approach. Then, a steel ball 34 was placed at P on the polyethylene terephthalate film 31 at a distance d1 (50 mm) upward from the upper end Q of the portion where the surface of the test piece was exposed, and then the time t (s) when the steel ball 34 reached R at a position at a distance d2 (50 mm) toward the lower portion of the test piece 32 from the upper end Q of the portion where the test piece 32 was exposed was measured with the time when the steel ball 34 passed the approach distance d1 (50 mm) being 0 s, and the time t was taken as the ball tack value. The ball tack value was obtained as the arithmetic mean of three measurements of the time t.

As the steel ball, one made of high carbon chromium bearing steel SUJ2 prescribed in JIS G 4805 and having a diameter of 11 mm was used.

For other than the above, the measurement was performed in accordance with JIS Z0237: 2009.

[Presence or Absence of Skin Layer and Skin Layer Thickness]

Cross sections of the thermally conductive sheets of the Examples and the Comparative Examples were observed by a scanning electron microscope ("SU3500" manufactured by Hitachi High-Technologies Corporation).

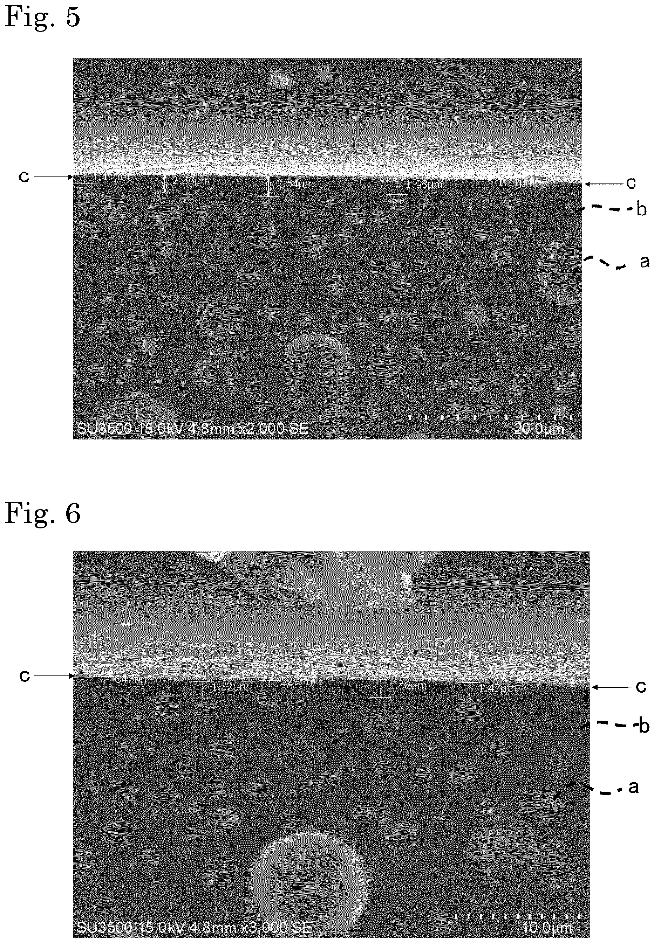

Fig. 5 shows one example of a scanning electron micrograph of a thermally conductive sheet fabricated using a sample 1 described later. A part looking black in the figure (b in the figure) is a silicone resin, a matrix, and a part looking white (a in the figure) is a thermally conductive filler dispersed in the matrix. c in the figure is a surface of the thermally conductive sheet. It is seen that the surface has a lower filling rate of the thermally conductive filler than other portions and has a skin layer. The thickness of the skin layer was obtained by drawing a perpendicular line in the direction of the inside of the thermally conductive sheet from the surface to obtain the distance h1 to the contact of the perpendicular line with the thermally conductive filler (for example, the portion of 1.11 $\mu$m shown in the upper left portion of Fig. 5), then similarly drawing a total of 50 perpendicular lines at equal intervals to obtain h1 to h50, excluding 10 large numerical values from among these, and averaging the remaining 40 measured values.

Fig. 6 shows one example of a scanning electron micrograph of a thermally conductive sheet fabricated using a sample 2. It was seen that the thermally conductive sheet also similarly had a skin layer on a surface.

(Example 1)

An alkenyl group-containing organopolysiloxane and a hydrogen organopolysiloxane (100 parts by mass in total) as an addition reaction-curable silicone, 120 parts by mass of graphitized carbon fibers (average fiber length 100 μm, aspect ratio 10, thermal conductivity 500 W/m·K, electrically conductive) as an anisotropic filling material, and 500 parts by mass of an aluminum oxide powder 1 (spherical, average particle diameter 5 μm, aspect ratio 1.0, insulating) as a non-anisotropic filler were mixed to obtain a mixed composition. The viscosity of the mixed composition was 100Pa.s.

Then, release films were disposed on upper and lower faces in a mold set at a predetermined thickness, and then the mixed composition was injected, and a magnetic field of 8 T was applied in the thickness direction to orient the graphitized carbon fibers in the thickness direction. Then, the mixed composition was heated at 80°C for 60 min to cure the addition reaction-curable silicone to obtain a sample 1 in a sheet shape having a thickness of 0.5 mm. The sample 1 was a sheet including a matrix including a silicone resin, and a thermally conductive filler, had skin layers formed on both surfaces, and had adhesiveness. The composition of the sample 1 is shown in Table 1.

One surface of the sample 1 in the sheet shape was irradiated with VUV in the air at room temperature (25°C) under the condition of an accumulated amount of light of 29 mJ/cm$^2$ using a VUV irradiation apparatus (trade name EXCIMER MINI, manufactured by Hamamatsu Photonics K.K.), to fabricate a thermally conductive sheet.

(Examples 2 to 7)

Thermally conductive sheets were fabricated as in Example 1 except that the accumulated amount of light of VUV irradiation was changed as shown in Table 2.

(Comparative Example 1)

A thermally conductive sheet was fabricated as in Example 1 except that VUV irradiation was not performed.

(Example 8)

An alkenyl group-containing organopolysiloxane and a hydrogen organopolysiloxane (100 parts by mass in total) as an addition reaction-curable silicone, and 400 parts by mass of an aluminum oxide powder 1 (spherical, average particle diameter 5 μm, aspect ratio 1.0, insulating), 200 parts by mass of an aluminum oxide powder 2 (spherical, average particle diameter 1 μm, aspect ratio 1.0, insulating), and 320 parts by mass of an aluminum oxide powder 3 (spherical, average particle diameter 40 μm, aspect ratio 1.0, insulating) as non-anisotropic fillers were mixed to obtain a mixed composition. The viscosity of the mixed composition was 60Pa.s.

Then, the mixed composition was sandwiched between a pair of release films and stretched by a stretching roll so that the thickness of the mixed composition was 0.5 mm. Subsequently, the mixed composition was heated at 80°C for 60 min to cure the addition reaction-curable silicone to obtain a sample 2 in a sheet shape having a thickness of 0.5 mm. The sample 2 was a sheet including a matrix including a silicone resin, and a thermally conductive filler, had skin layers formed on both surfaces, and had adhesiveness. The composition of the sample 2 is shown in Table 2.

One surface of the sample 2 in the sheet shape was irradiated with VUV in the air at room temperature (25°C) under the condition of an accumulated amount of light of 430 mJ/cm$^2$ using a VUV irradiation apparatus (trade name EXCIMER MINI, manufactured by Hamamatsu Photonics K.K.), to fabricate a thermally conductive sheet.

(Comparative Example 2)

A thermally conductive sheet was fabricated as in Example 8 except that VUV irradiation was not performed.

Table 1

| | Sample 1 (parts by mass) | Sample 1 (parts by volume) | Sample 1 (% by volume) | Sample 2 (parts by mass) | Sample 2 (parts by volume) | Sample 2 (% by volume) |
|---|---|---|---|---|---|---|
| Silicone resin | 100 | 100 | 35 | 100 | 100 | 30 |
| Graphitized carbon fibers | 120 | 55 | 19 | 0 | 0 | 0 |
| Aluminum oxide powder 1 (5 μm) | 500 | 128 | 45 | 400 | 103 | 31 |
| Aluminum oxide powder 2 (1 μm) | 0 | 0 | 0 | 200 | 51 | 15 |

(continued)

|  | Sample 1 (parts by mass) | Sample 1 (parts by volume) | Sample 1 (% by volume) | Sample 2 (parts by mass) | Sample 2 (parts by volume) | Sample 2 (% by volume) |
|---|---|---|---|---|---|---|
| Aluminum oxide powder 3 (40 $\mu$m) | 0 | 0 | 0 | 320 | 82 | 24 |

Table 2

| | Sample type | VUV irradiation conditions | | Skin layer thickness (μm) | XPS analysis | Adhesiveness | Surface properties | | | Compression ratio, thermal resistance | | Surfaces of thermally conductive sheet | |
| --- | --- | --- | --- | --- | --- | --- | --- | --- | --- | --- | --- | --- | --- |
| | | Irradiation time (s) | Accumulated amount of light (mJ/cm²) | | 1 (104) /I (102) | Ball tack value | Sa (μm) | Spc (1/mm) | Sdr | 20N compression ratio (%) | 20% compression thermal resistance value (°C/W) | One face | The other face |
| Example 1 | Sample 1 | 2 | 29 | 2.3 | 0.13 | 6.1 | 1.58 | 902.6 | 0.32 | 19.0 | 0.52 | Slightly adhesive face | Adhesive face |
| Example 2 | Sample 1 | 10 | 143 | 2.3 | 0.16 | 5.8 | 1.32 | 874.6 | 0.30 | 17.0 | 0.52 | Slightly adhesive face | Adhesive face |
| Example 3 | Sample 1 | 30 | 430 | 2.3 | 0.22 | 2.0 | 1.16 | 814.1 | 0.25 | 15.9 | 0.49 | Slightly adhesive face | Adhesive face |
| Example 4 | Sample 1 | 60 | 860 | 2.3 | 0.43 | 0.3 | 0.99 | 763.0 | 0.22 | 16.3 | 0.50 | Non-adhesive face | Adhesive face |
| Example 5 | Sample 1 | 90 | 1290 | 2.3 | 0.60 | 0.3 | 0.88 | 744.4 | 0.20 | 16.6 | 0.50 | Non-adhesive face | Adhesive face |
| Example 6 | Sample 1 | 120 | 1720 | 2.3 | 0.81 | 0.3 | 0.82 | 726.3 | 0.18 | 17.0 | 0.51 | Non-adhesive face | Adhesive face |
| Example 7 | Sample 1 | 150 | 2150 | 2.3 | 0.95 | 0.3 | 0.76 | 707.2 | 0.18 | 18.1 | 0.52 | Non-adhesive face | Adhesive face |
| Comparative Example 1 | Sample 1 | 0 | 0 | 2.3 | 0.12 | 15.7 | 1.59 | 930.5 | 0.34 | 22.7 | 0.50 | Adhesive face | Adhesive face |
| Example 8 | Sample 2 | 30 | 430 | 1.2 | 0.24 | 3.1 | 1.15 | 801.4 | 0.23 | 11.4 | 1.58 | Slightly adhesive face | Adhesive face |

EP 3 981 829 B1

| | Sample type | VUV irradiation conditions | | Skin layer thickness ($\mu$m) | XPS analysis | Adhesiveness | Surface properties | | | Compression ratio, thermal resistance | | Surfaces of thermally conductive sheet | |
|---|---|---|---|---|---|---|---|---|---|---|---|---|---|
| | | Irradiation time (s) | Accumulated amount of light (mJ/cm$^2$) | | 1 (104) /I (102) | Ball tack value | Sa ($\mu$m) | Spc (1/mm) | Sdr | 20N compression ratio (%) | 20% compression thermal resistance value (°C/W) | One face | The other face |
| Comparative Example 2 | Sample 2 | 0 | 0 | 1.2 | 0.12 | 16.8 | 1.62 | 913.2 | 0.33 | 15.6 | 1.60 | Adhesive face | Adhesive face |

EP 3 981 829 B1

**EP 3 981 829 B1**

It was seen that the thermally conductive sheets manufactured in the Examples had skin layers, and therefore the falling off of the thermally conductive filler was less likely to occur. Further, from the results of the XPS analysis, it was seen that an oxide layer was formed on the face subjected to VUV irradiation, and with the formation of the oxide layer, the adhesiveness decreased. One face (the face irradiated with VUV) of each of the thermally conductive sheets of the Examples was a slightly adhesive face or a non-adhesive face, and the other face (the face not irradiated with VUV) was an adhesive face, and thus the thermally conductive sheets of the present invention were those that were easily slid when incorporated into electronic equipment.

The Sa, Spc, and Sdr of the surface of each of the thermally conductive sheets of the Examples on the oxide layer side were lower than those of the thermally conductive sheets of the Comparative Examples, and the smoothness was excellent. The smoothness of the thermally conductive sheets is excellent, and thus when the surfaces of adherends such as a heating element and a heat-dissipating body are smooth, the close adhesiveness between the thermally conductive sheet and the adherends is excellent, and efficient heat dissipating is possible.

The 20% compression thermal resistance value of each of the thermally conductive sheets of the Examples is almost unchanged compared with the Comparative Examples, and the thermal conductivity is well maintained. Therefore, by while making one surface a slightly adhesive face, making the other face an adhesive face, the thermally conductive sheets of Examples 1 to 3 and 8 have moderate slidability, and the thermal conductivity is also well maintained, while the falling off of the thermally conductive filler is prevented. In this case, one face of the thermally conductive sheet is a slightly adhesive face, and thus when the thermally conductive sheet is attached to the heating element and heat-dissipating body of electronic equipment, it exhibits moderate slidability and is easily attached to the desired position, and after the attachment, positional displacement is less likely to occur. Further, when the heat-dissipating body is subsequently removed from the heating element of the electronic equipment, it can always be removed in a state in which the thermally conductive sheet adheres to one to which the adhesive face is adhered, and therefore replacement and repair are easy.

On the other hand, when the accumulated amount of light of VUV is large, and a non-adhesive face (having a ball tack value of less than 1) is formed, as shown in Examples 4 to 7, a thermally conductive sheet having better slidability is obtained because one face is a non-adhesive face, and the smoothness of the non-adhesive face is high. Such excellent slidability is useful for applications where the thermally conductive sheet is slid in a compressed state.

In contrast to these, the thermally conductive sheets of Comparative Examples 1 and 2 were thermally conductive sheets having poor slidability because both faces were adhesive faces.

Reference Signs List

| | |
|---|---|
| 10 | thermally conductive sheet |
| 11a | one surface |
| 11b | the other surface |
| 12 | matrix |
| 13 | anisotropic filler |
| 14 | non-anisotropic filler |
| 15a | skin layer |
| 15b | skin layer |
| 16a | oxide layer |
| 21 | thermal insulator |
| 22 | lower copper block |
| 23 | upper copper block |
| 24 | heater |
| 25 | heat sink |
| 26 | load cell |
| S | test piece |
| $\theta_{j0}$ | temperature of upper copper block |
| $\theta_{j1}$ | temperature of lower copper block |
| 31 | polyethylene terephthalate film |
| 32 | test piece |
| 33 | flat plate |
| 34 | steel ball |

18

**Claims**

1. A thermally conductive sheet comprising a matrix comprising a silicone resin, and a thermally conductive filler,

the thermally conductive sheet comprising a skin layer on a surface, and
comprising an oxide layer on a surface of the skin layer,
wherein the thermally conductive filler comprises an anisotropic filler and a non-anisotropic filler, the anisotropic filler comprises carbon fiber,
wherein the carbon fiber is oriented in the thickness direction of the thermally conductive sheet,
wherein the oxide layer is a layer of silicone resin that has partially turned into silica by irradiation with VUV,
wherein for a surface of the thermally conductive sheet on a side comprising the oxide layer, intensity at a binding energy of 104 eV to intensity at a binding energy of 102 eV (I(104)/I(102)) is 0.13 or more in a photoelectron spectrum obtained by surface analysis by X-ray photoelectron spectroscopy,
wherein the surface analysis by X-ray photoelectron spectroscopy is measured as indicated in the description.

2. A thermally conductive sheet comprising a matrix comprising a silicone resin, and a thermally conductive filler,

the thermally conductive sheet comprising a skin layer on a surface, and
comprising an oxide layer on a surface of the skin layer,
wherein the thermally conductive filler comprises an anisotropic filler and a non-anisotropic filler, the anisotropic filler comprises carbon fiber,
wherein the carbon fiber is oriented in the thickness direction of the thermally conductive sheet,
wherein the oxide layer is a layer of silicone resin that has partially turned into silica by irradiation with VUV,
wherein the surface of the thermally conductive sheet on the side comprising the oxide layer has an arithmetic mean height (Sa) of 1.58 $\mu$m or less, an arithmetic mean peak curvature (Spc) of 910 [1/mm] or less, and a developed interfacial area ratio (Sdr) of 0.32 or less,
wherein the arithmetic mean height (Sa), the arithmetic mean peak curvature (Spc), and the developed interfacial area ratio (Sdr) are measured as indicated in the description.

3. A thermally conductive sheet comprising a matrix comprising a silicone resin, and a thermally conductive filler,

the thermally conductive sheet comprising a skin layer on a surface, and
comprising an oxide layer on a surface of the skin layer,
wherein the thermally conductive filler comprises an anisotropic filler and a non-anisotropic filler, the anisotropic filler comprises carbon fiber,
wherein the carbon fiber is oriented in the thickness direction of the thermally conductive sheet,
wherein the oxide layer is a layer of silicone resin that has partially turned into silica by irradiation with VUV,
wherein the surface of the thermally conductive sheet on the side comprising the oxide layer has a ball tack value of 10 s or less as measured by a measuring apparatus in accordance with JIS Z0237: 2009 by a method of the following (1) to (2):

(1) a test piece comprising the thermally conductive sheet is affixed to a flat plate so that a face that is a target of a ball tack test is a surface, and the flat plate is mounted so that an inclination angle $\alpha$ is 8°,
(2) a polyethylene terephthalate film is affixed to an upper portion of the test piece to form an approach, a steel ball having a diameter of 11 mm is placed on the polyethylene terephthalate film at a distance d1 (50 mm) upward from an upper end Q of a portion where the surface of the test piece is exposed, and then time (s) when the steel ball reaches R at a position at a distance d2 (50 mm) toward a lower portion of the test piece from the upper end Q of the portion where the surface of the test piece is exposed, with time when the steel ball passes an approach distance d1 (50 mm) being 0 s, is taken as a ball tack value,

wherein the ball tack value is measured as indicated in the description.

4. The thermally conductive sheet according to any one of claims 1 to 3, wherein a content of the thermally conductive filler is 60% by volume or more.

5. A method for manufacturing a thermally conductive sheet comprising a matrix comprising a silicone resin, and a thermally conductive filler,

the thermally conductive sheet comprising a skin layer on a surface, and

comprising an oxide layer on a surface of the skin layer,

wherein the thermally conductive filler comprises an anisotropic filler and a nonanisotropic filler, the anisotropic filler comprises carbon fiber,

wherein the carbon fiber is oriented in the thickness direction of the thermally conductive sheet,

wherein the oxide layer is a layer of silicone resin that has partially turned into silica,

wherein the method for manufacturing a thermally conductive sheet comprises a skin layer forming step and an oxide layer forming step,

wherein the oxide layer forming step comprises a vacuum ultraviolet irradiation step,

and wherein an accumulated amount of light in the vacuum ultraviolet irradiation step is 25 to 800 mJ/cm$^2$.

6. The method for manufacturing the thermally conductive sheet according to claim 5, wherein the skin layer forming step comprises the following steps (S1) and (S2), and an oxide layer is formed on a surface cured in a non-open state in the (S2) step:

(S1) a step of preparing a mixed composition comprising a reaction-curable silicone and a thermally conductive filler,

(S2) a step of forming the mixed composition into a sheet shape and curing the mixed composition in the sheet shape with at least one surface of the mixed composition in the sheet shape being in a non-open state.

**Patentansprüche**

1. Wärmeleitende Folie, umfassend eine Matrix, die ein Silikonharz, und einen wärmeleitenden Füllstoff umfasst,

wobei die wärmeleitende Folie eine Hautschicht auf einer Oberfläche umfasst, und eine Oxidschicht auf einer Oberfläche der Hautschicht umfasst,

wobei der wärmeleitende Füllstoff einen anisotropen Füllstoff und einen nichtanisotropen Füllstoff umfasst, wobei der anisotrope Füllstoff Kohlenstofffaser umfasst, wobei die Kohlenstofffaser in der Dickenrichtung der wärmeleitenden Folie orientiert ist,

wobei die Oxidschicht eine Schicht aus Silikonharz ist, die sich durch Bestrahlung mit VUV teilweise in Siliziumdioxid verwandelt hat,

wobei für eine Oberfläche der wärmeleitenden Folie auf einer Seite, die die Oxidschicht umfasst, die Intensität bei einer Bindungsenergie von 104 eV zur Intensität bei einer Bindungsenergie von 102 eV (I(104)/I(102)) in einem durch Oberflächenanalyse mittels Röntgen-Photoelektronenspektroskopie erhaltenen Photoelektronenspektrum 0,13 oder mehr beträgt,

wobei die Oberflächenanalyse durch Röntgen-Photoelektronenspektroskopie wie in der Beschreibung angegeben gemessen wird.

2. Wärmeleitende Folie, umfassend eine Matrix, die ein Silikonharz umfasst, und einen wärmeleitenden Füllstoff,

wobei die wärmeleitende Folie eine Hautschicht auf einer Oberfläche umfasst, und eine Oxidschicht auf einer Oberfläche der Hautschicht umfasst,

wobei der wärmeleitende Füllstoff einen anisotropen Füllstoff und einen nichtanisotropen Füllstoff umfasst, wobei der anisotrope Füllstoff Kohlenstofffaser umfasst, wobei die Kohlenstofffaser in der Dickenrichtung der wärmeleitenden Folie orientiert ist,

wobei die Oxidschicht eine Schicht aus Silikonharz ist, die sich durch Bestrahlung mit VUV teilweise in Siliziumdioxid verwandelt hat,

wobei die Oberfläche der wärmeleitenden Folie auf der Seite, die die Oxidschicht umfasst, eine arithmetische mittlere Höhe (Sa) von 1,58 μm oder weniger, eine arithmetische mittlere Spitzenkrümmung (Spc) von 910 [1/mm] oder weniger und ein entwickeltes Grenzflächenverhältnis (Sdr) von 0,32 oder weniger aufweist,

wobei die arithmetische mittlere Höhe (Sa), die arithmetische mittlere Spitzenkrümmung (Spc) und das entwickelte Grenzflächenflächenverhältnis (Sdr) wie in der Beschreibung angegeben gemessen werden.

3. Wärmeleitende Folie, umfassend eine Matrix, die ein Silikonharz umfasst, und einen wärmeleitenden Füllstoff,

wobei die wärmeleitende Folie eine Hautschicht auf einer Oberfläche umfasst, und eine Oxidschicht auf einer Oberfläche der Hautschicht umfasst,

wobei der wärmeleitende Füllstoff einen anisotropen Füllstoff und einen nichtanisotropen Füllstoff umfasst, wobei der anisotrope Füllstoff Kohlenstofffaser umfasst, wobei die Kohlenstofffaser in der Dickenrichtung der wärmeleitenden Folie orientiert ist,

wobei die Oxidschicht eine Schicht aus Silikonharz ist, die sich durch Bestrahlung mit VUV teilweise in Siliziumdioxid verwandelt hat, wobei die Oberfläche der wärmeleitenden Folie auf der Seite, die die Oxidschicht umfasst, einen Ball-Tack-Wert von 10 s oder weniger aufweist, gemessen mit einem Messgerät gemäß JIS Z0237: 2009 nach einem der folgenden Verfahren (1) bis (2):

(1) ein Teststück, das die wärmeleitende Folie umfasst, wird an einer flachen Platte befestigt, so dass eine Fläche, die ein Ziel eines Ball-Tack-Tests ist, eine Oberfläche ist, und die flache Platte wird so montiert, dass ein Neigungswinkel $\alpha$ 8° beträgt,

(2) eine Polyethylenterephthalatfolie wird an einem oberen Abschnitt des Teststücks befestigt, um eine Annäherung zu bilden, eine Stahlkugel mit einem Durchmesser von 11 mm wird auf der Polyethylenterephthalatfolie in einem Abstand d1 (50 mm) nach oben von einem oberen Ende Q eines Abschnitts, wo die Oberfläche des Teststücks freiliegt, platziert und dann wird die Zeit (s), in der die Stahlkugel R an einer Position in einem Abstand d2 (50 mm) in Richtung eines unteren Abschnitts des Teststücks vom oberen Ende Q des Abschnitts, wo die Oberfläche des Teststücks freiliegt, erreicht, wobei die Zeit, in der die Stahlkugel eine Annäherungsstrecke d1 (50 mm) passiert, 0 s beträgt, als Ball-Tack-Wert genommen

wobei der Ball-Tack-Wert wie in der Beschreibung angegeben gemessen wird.

4. Wärmeleitende Folie nach einem der Ansprüche 1 bis 3, wobei der Gehalt an wärmeleitendem Füllstoff 60 Vol.-% oder mehr beträgt.

5. Verfahren zur Herstellung einer wärmeleitenden Folie umfassend eine Matrix, die ein Silikonharz umfasst, und einen wärmeleitenden Füllstoff,

wobei die wärmeleitende Folie eine Hautschicht auf einer Oberfläche umfasst, und eine Oxidschicht auf einer Oberfläche der Hautschicht umfasst,

wobei der wärmeleitende Füllstoff einen anisotropen Füllstoff und einen nichtanisotropen Füllstoff umfasst, wobei der anisotrope Füllstoff Kohlenstofffaser umfasst, wobei die Kohlenstofffaser in der Dickenrichtung der wärmeleitenden Folie orientiert ist,

wobei die Oxidschicht eine Schicht aus Silikonharz ist, die sich teilweise in Siliziumdioxid verwandelt hat,

wobei das Verfahren zur Herstellung einer wärmeleitenden Folie einen Schritt zur Bildung einer Hautschicht und einen Schritt zur Bildung einer Oxidschicht umfasst, wobei der Schritt zur Bildung einer Oxidschicht einen Schritt der Vakuum-Ultraviolettbestrahlung umfasst,

und wobei eine akkumulierte Lichtmenge in dem Schritt der Vakuum-Ultraviolettbestrahlung 25 bis 800 mJ/cm$^2$ beträgt.

6. Verfahren zur Herstellung der wärmeleitenden Folie nach Anspruch 5, wobei der Schritt zur Bildung einer Hautschicht die folgenden Schritte (S1) und (S2) umfasst, und im Schritt (S2) eine Oxidschicht auf einer in einem nicht geöffneten Zustand ausgehärteten Oberfläche gebildet wird:

(S1) einen Schritt der Herstellung einer gemischten Zusammensetzung, die ein reaktionshärtbares Silikon und einen wärmeleitenden Füllstoff umfasst,

(S2) einen Schritt des Formens der gemischten Zusammensetzung in eine Folienform und des Aushärtens der gemischten Zusammensetzung in der Folienform, wobei mindestens eine Oberfläche der gemischten Zusammensetzung in der Folienform in einem nicht geöffneten Zustand ist.

## Revendications

1. Feuille thermiquement conductrice comportant une matrice comportant une résine de silicone et une charge thermiquement conductrice,

la feuille thermiquement conductrice comportant une couche de peau sur une surface, et comportant une couche d'oxyde sur une surface de la couche de peau, dans laquelle la charge thermiquement conductrice comporte une charge anisotrope et une charge non anisotrope, la charge anisotrope comportant de la fibre de carbone,

dans laquelle la fibre de carbone est orientée dans la direction d'épaisseur de la feuille thermiquement conductrice,

dans laquelle la couche d'oxyde est une couche de résine de silicone qui s'est partiellement transformée en silice par irradiation avec un rayonnement VUV,

dans laquelle, pour une surface de la feuille thermiquement conductrice sur un côté comportant la couche d'oxyde, l'intensité à une énergie de liaison de 104 eV jusqu'à l'intensité à une énergie de liaison de 102 eV (I(104)/I(102)) est de 0,13 ou plus dans un spectre de photoélectrons obtenu par analyse de surface par spectroscopie de photoélectrons X,

dans laquelle l'analyse de surface par spectroscopie de photoélectrons X est mesurée comme indiqué dans la description.

2. Feuille thermiquement conductrice comportant une matrice comportant une résine de silicone et une charge thermiquement conductrice,

la feuille thermiquement conductrice comportant une couche de peau sur une surface, et comportant une couche d'oxyde sur une surface de la couche de peau,

dans laquelle la charge thermiquement conductrice comporte une charge anisotrope et une charge non anisotrope, la charge anisotrope comportant de la fibre de carbone,

dans laquelle la fibre de carbone est orientée dans la direction d'épaisseur de la feuille thermiquement conductrice,

dans laquelle la couche d'oxyde est une couche de résine de silicone qui s'est partiellement transformée en silice par irradiation avec un rayonnement VUV,

dans laquelle la surface de la feuille thermiquement conductrice sur le côté comportant la couche d'oxyde a une hauteur moyenne arithmétique (Sa) de 1,58 μm ou moins, une courbure moyenne arithmétique des pics (Spc) de 910 [1/mm] ou moins, et un rapport de surface interfaciale développée (Sdr) de 0,32 ou moins,

dans laquelle la hauteur moyenne arithmétique (Sa), la courbure moyenne arithmétique des pics (Spc) et le rapport de surface interfaciale développée (Sdr) sont mesurés comme indiqué dans la description.

3. Feuille thermiquement conductrice comportant une matrice comportant une résine de silicone et une charge thermiquement conductrice,

la feuille thermiquement conductrice comportant une couche de peau sur une surface, et comportant une couche d'oxyde sur une surface de la couche de peau,

dans laquelle la charge thermiquement conductrice comporte une charge anisotrope et une charge non anisotrope, la charge anisotrope comportant de la fibre de carbone,

dans laquelle la fibre de carbone est orientée dans la direction d'épaisseur de la feuille thermiquement conductrice,

dans laquelle la couche d'oxyde est une couche de résine de silicone qui s'est partiellement transformée en silice par irradiation avec un rayonnement VUV,

dans laquelle la surface de la feuille thermiquement conductrice sur le côté comportant la couche d'oxyde a une valeur de pégosité à la bille de 10 s ou moins, lorsqu'elle est mesurée par un appareil de mesure conformément à la norme JIS Z0237:2009 par un procédé parmi les procédés (1) à (2) suivants :

(1) une éprouvette d'essai comportant la feuille thermiquement conductrice est fixée à une plaque plate de sorte qu'une face qui est une cible d'un essai de pégosité à la bille est une surface, et la plaque plate est montée de sorte qu'un angle d'inclinaison α est de 8°,

(2) un film de polyéthylène téréphtalate est fixé à une partie supérieure de l'éprouvette d'essai pour former une approche, une bille d'acier ayant un diamètre de 11 mm est placée sur le film de polyéthylène téréphtalate à une distance d1 (50 mm) vers le haut par rapport à une extrémité supérieure Q d'une partie où la surface de l'éprouvette d'essai est exposée, et l'instant (s) où la bille d'acier atteint R à une position située à une distance d2 (50 mm) vers une partie inférieure de l'éprouvette d'essai par rapport à l'extrémité supérieure Q de la partie où la surface de l'éprouvette d'essai est exposée, l'instant où la bille d'acier franchit une distance d'approche d1 (50 mm) étant égal à 0 s, est ensuite pris comme valeur de pégosité à la bille,

dans laquelle la valeur de pégosité à la bille est mesurée comme indiqué dans la description.

4. Feuille thermiquement conductrice selon l'une quelconque des revendications 1 à 3, dans laquelle une teneur en charge thermiquement conductrice est de 60 % en volume ou plus.

5. Procédé pour fabriquer une feuille thermiquement conductrice comportant une matrice comportant une résine de silicone et une charge thermiquement conductrice,

la feuille thermiquement conductrice comportant une couche de peau sur une surface, et
comportant une couche d'oxyde sur une surface de la couche de peau,
dans lequel la charge thermiquement conductrice comporte une charge anisotrope et une charge non anisotrope,
la charge anisotrope comportant de la fibre de carbone,
dans lequel la fibre de carbone est orientée dans la direction d'épaisseur de la feuille thermiquement conductrice,
dans lequel la couche d'oxyde est une couche de résine de silicone qui s'est partiellement transformée en silice,
dans lequel le procédé pour fabriquer une feuille thermiquement conductrice comporte une étape de formation de couche de peau et une étape de formation de couche d'oxyde,
dans lequel l'étape de formation de couche d'oxyde comporte une étape d'irradiation de rayonnement ultraviolet sous vide,
et dans lequel une quantité cumulée de lumière à l'étape d'irradiation de rayonnement ultraviolet sous vide est de 25 à 800 mJ/cm$^2$.

6. Procédé pour fabriquer la feuille thermiquement conductrice selon la revendication 5, dans lequel l'étape de formation de couche de peau comporte les étapes (S1) et (S2) suivantes, et une couche d'oxyde est formée sur une surface durcie dans un état non ouvert à l'étape (S2) :

(S1) une étape consistant à préparer une composition mélangée comportant une silicone durcissable par réaction et une charge thermiquement conductrice,
(S2) une étape consistant à former la composition mélangée pour obtenir une forme de feuille et durcir la composition mélangée ayant la forme de feuille, avec au moins une surface de la composition mélangée ayant la forme de feuille étant dans un état non ouvert.

## Fig. 1

## Fig. 2

## Fig. 3

## Fig. 4

Fig. 5

Fig. 6

**EP 3 981 829 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016000506 A
- WO 2016208458 A
- JP 2011231242 A
- JP 2001316502 A
- JP H10150132 A